# EUROPEAN PATENT APPLICATION

(11) **EP 1 298 716 A1**
(43) Date of publication of application: **02.04.2003**
(21) Application number: 01121847.6
(22) Date of filing: 11.09.2001
(51) Int. Cl.: H01L 21/306, H01L 21/316, H01L 21/02, H01L 21/8242, H01L 21/324

(54) **Method for roughening a surface of a semiconductor substrate**

(71) Applicant: Infineon Technologies AG, 81669 München (DE)
(72) Inventor: Cappellani, Annalisa, 96100 Siracusa (DE); Goldbach, Matthias, Dr., 01099 Dresden (DE)
(74) Representative: Epping Hermann & Fischer

(57) **Abstract**

A semiconductor substrate (5) comprising a surface (10) is arranged in a furnace. Oxygen and an innert gas like argon or nitrogen are introduced into a furnace, maintaining the oxygen concentration in the furnace below 10 %. The substrate (5) is annealed at a temperature above 950 °C and mesopores (15) are formed in the surface (10) of the semiconductor substrate (5).

## Description

The present invention relates to a method for roughening a surface of a semiconductor substrate.

In the technical field of semiconductor manufacturing, it is well-known to produce dynamic random access memories (DRAMs) with memory cells comprising a selection transistor and a storage capacitor. The progress in semiconductor manufacturing is driven by the reduction of the feature size. Accordingly the number of functions arranged on a given area of a substrate can be increased.

As the surface area for a single memory cell decreases, the capacity of the storage capacitor is decreasing as well. For proper operation of the memory cell, a certain minimum capacity (typically in the order of 30 femto farad) is mandatory for the storage capacitor. If the capacity of the storage capacitor is too small, the charge stored in the storage capacitor is not sufficient to produce a detectable signal on the bit line when the selection transistor is opened. In this case, the information stored in the memory cell is lost and the memory cell is not operating in the desired way.

Several ways are known in the prior art to overcome the problem of shrinking feature size. For example, a storage capacitor is formed in a deep trench to maintain a large capacitor area with a high capacity while using a small amount of the surface of the substrate. Another method to create a capacitor with a high capacity is a stacked capacitor which is arranged on the surface of the semiconductor substrate, above the selection transistor.

To increase the capacitor area, it is also known in the prior art to arrange hemispherical grains on the electrodes of the capacitor. Hemispherical grains result in an increased capacitor area which increases the capacity. To build hemispherical grains, it is known to deposit a polysilicon layer with a high roughness.

In view of the prior art, it is an objective of the present invention to provide a method for roughening a surface of a semiconductor substrate in a way that the capacitor area is increased.

This objective is solved by a method for roughening a surface of a semiconductor substrate comprising the steps:
- providing a semiconductor substrate comprising a surface;
- arranging the semiconductor substrate in a furnace;
- introducing a process gas into the furnace comprising oxygen and an innert gas, preferrably argon or nitrogen;
- maintaining the oxygen concentration in the furnace below 10 %;
- annealing the substrate at a temperature above 950 °C in order to form mesopores in the surface of the semiconductor substrate.

Further advantages, features, aspects and details of the invention are evident from the dependent claims.

The provided method is applicable for example in DRAM technology for roughening the capacity area of a storage capacitor. The inventive process is intended to produce mesopores in the capacity area of the storage capacitor for enlarging the active area of the storage capacitor. This results in an increased storage capacity. An advantage of the inventive method for roughening the surface of a semiconductor substrate is the lacking of additional etching gases as chlorine or fluorine which are not necessary for the present invention. The forming of mesopores just uses process gases which are well-known for semiconductor manufacturing.

Advantageously, the invention increases the surface area and therefore the capacity of the storage capacitor.

According to an embodiment of the present invention, the substrate is annealed at a temperature above 1000 °C. This provides enough energy to start and to pursue the reaction.

According to another embodiment of the present invention, the oxygen concentration in the furnace is less than 1 %. This enables the formation of silicon monoxide and suppresses the formation of silicon dioxide.

According to another embodiment of the present invention, the annealing of the substrate is performed between 5 seconds and 40 seconds. A preferred time period is about 30 seconds.

According to another embodiment, the substrate is etched in a solution containing water, ammonium hydroxide and hydrogen peroxide (H₂0, NH₄OH and H₂O₂) to smooth the mesopores. This provides pores with improved regularity an avoids corners. It also widens the pores.

In a further embodiment of the present invention, the mesopores are formed having a diameter between 10 nm and 50 nm. The given range for the diameter of the mesopores is suitable for enlarging the area of the capacitor in a way that improves the capacity of the storage capacitor.

In a further embodiment of the present invention, the ratio between diameter and depth of the mesopores is between 0.25 to 4.

In a further embodiment of the present invention, the process parameters for oxidising the silicon containing substrate are chosen in a way, that the silicon containing substrate is oxidised to silicon monoxide, which is volatile and sublimates from the surface of the semiconductor substrate. This means that the surface of the semiconductor substrate is roughened due to oxidation to silicon monoxide, which is afterwards sublimated due to the high temperature of above 950 °C.

According to a further embodiment of the present invention, the substrate is etched several times in the solution to smooth the mesopores. This provides pores with improved regularity an avoids corners. It also widens the pores.

The invention will be better understood with reference to the following description of embodiments of the invention taken in conjunction with the accompanying drawings. Equal references show equal or functionally equal elements.

The figures show:
- Figure 1: a cross-section through a semiconductor substrate with a roughened surface comprising mesopores;
- Figure 2: a SEM (Scanning Electron Microscope) picture of a cross-section through a substrate comprising mesopores;
- Figure 3: a cross section of a DRAM cell with an inset showing a magnification of the electrodes and the dielectric layer of the storage capacitor.

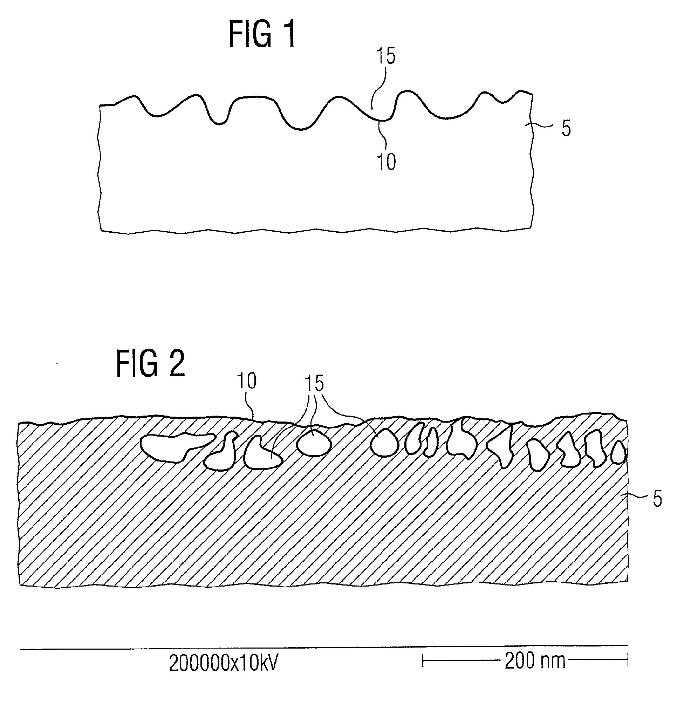

Figure 1 shows a cross section of a semiconductor substrate 5 comprising a surface 10. The surface 10 of the semiconductor substrate 5 comprises at least one mesopore 15. Typically, the surface 10 of the semiconductor substrate 5 comprises several mesopores 15 which increase the surface area of the semiconductor substrate 5. The semiconductor substrate 5, for example, contains silicon.

A method for roughening the surface 10 of the semiconductor substrate 5 to build the mesopores 15 in the surface 10 of the semiconductor substrate 5 is to arrange the semiconductor substrate 5 in a process chamber like a furnace. Oxygen and an inert gas like argon or nitrogen are introduced into the process chamber. The oxygen concentration in the process chamber is kept below 10 %. The semiconductor substrate 5 is annealed to a temperature above 950 °C and above 1 000 °C in a preferred embodiment. The semiconductor substrate 5 is annealed in the furnace for a time between 5 seconds and 40 seconds.

For building the mesopores in a substrate 5 containing silicon, the silicon can be provided mono crystalline, polycrystalline or amorphous. The silicon can also be doped to form n-type silicon or p-type silicon.

Advantageously, the inventive method is selective to silicon dioxide and silicon nitride which can mask the surface 10 of the semiconductor substrate 5 in areas where the surface 10 of the semiconductor substrate 5 should not be roughened by the inventive method.

Advantageously, the mesopore formation mechanism is simple, cheap, and well-controllable. The process can be used wherever a silicon area enhancement is required. The process is applicable to any capacitor with at least one electrode made of silicon.

For example, the capacitor could be a trench capacitor or a stacked capacitor of a DRAM cell.

In a preferred embodiment of the present invention, the oxygen concentration in the furnace is kept below 1 %.

Figure 2 shows a SEM (Scanning Electron Microscope) picture or a cross section of a silicon substrate including mesopores 15 formed by the inventive method.

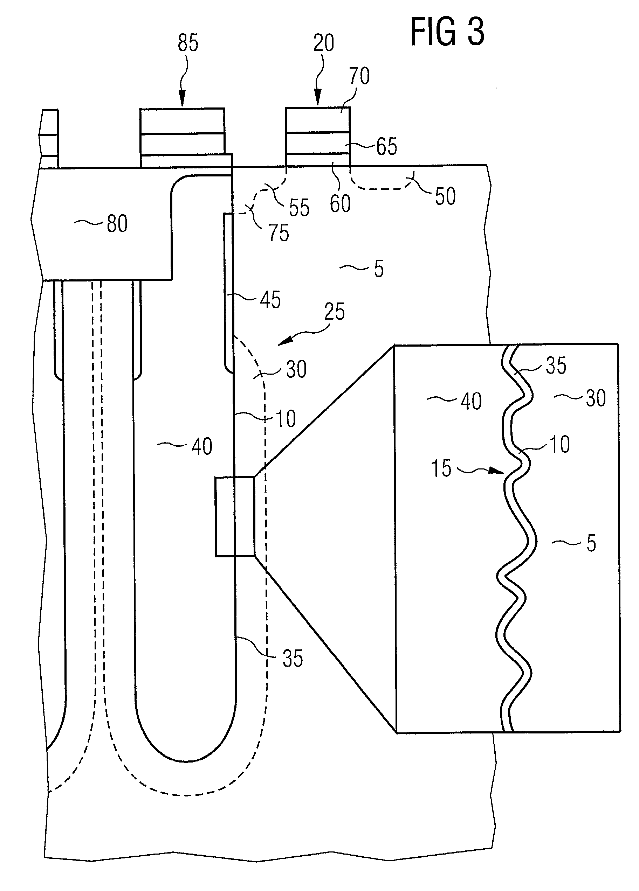

Figure 3 shows a cross section of a DRAM semiconductor memory cell comprising a trench capacitor and a planar selection field effect transistor 20. The selection field effect transistor 20 is arranged on the surface 10 of the substrate 5. A trench capacitor 25 is arranged in the substrate 5. The trench capacitor 25 comprises an outer trench capacitor electrode 20 arranged in the substrate 5 with a high doping concentration, an inner trench capacitor electrode arranged in the trench capacitor and a node dielectric 35, which separates the outer trench capacitor electrode 30 from the inner trench capacitor electrode 40. Additionally, a collar isolation 45 is arranged on the side wall of the trench capacitor 25 for isolation purposes.

The selection field effect transistor 20 comprises a source region 50 and a drain region 55, which are arranged in the semiconductor substrate 5. On top of the surface 10, the field effect transistor 20 comprises a gate oxide 60, a first gate electrode 65 and a second gate electrode 70.

The selection transistor 20 is connected through its drain region 55 and a buried strap 75 with the inner trench capacitor electrode 40. On top of the trench capacitor 25, a shallow trench isolation (STI) and on top of the STI, a passing word line 85 is arranged.

The inset in figure 3 shows a magnification of the surface 10 of the semiconductor substrate 5, which is arranged between the outer trench capacitor electrode 30 and the inner trench capacitor electrode 40. In the surface 10 of the semiconductor substrate 5, mesopores 15 are arranged. The node dielectric 35 is arranged on the surface 10.

A method for manufacturing the trench capacitor with a silicon electrode comprises the steps of building the trench for the trench capacitor and forming the collar isolation 45 in the upper part of the trench. The collar isolation 45 protects the collar region from being attacked by the inventive method for forming mesopores. The forming of the outer trench capacitor electrode 30 can be done before or after the forming of the mesopores 15 by introducing dopants into the semiconductor substrate 5. The substrate is annealed at higher temperatures than 950 °C in an inert ambient such as nitrogen with a controlled amount of oxygen of less then 10 % in total gas flow.

The shape of the mesopores can be smoothened, for example rounded, by a single wet etch step comprising H₂0, NH₄OH and H₂O₂ (SC1). The smoothening of the mesopores does not add additional complexity to the process since it is needed as a preclean before the node dielectric 35 is formed on the surface 10.

## Claims

1. Method for roughening a surface of a semiconductor substrate (5) comprising the steps:
- providing a semiconductor substrate (5) comprising a surface (10);
- arranging the semiconductor substrate (5) in a furnace;
- introducing a process gas into the furnace comprising oxygen and an innert gas, preferrably argon or nitrogen;
- maintaining the oxygen concentration in the furnace below 10 %;
- annealing the substrate (5) at a temperature above 950 °C in order to form mesopores (15) in the surface (10) of the semiconductor substrate (5).

2. Method according to claim 1,
**characterised in that**
the substrate (5) is annealed at a temperature above 1000 °C.

3. Method according to one of the claims 1 or 2,
**characterised in that**
the oxygen concentration in the furnace is less than 1 %.

4. Method according to one of the claims 1 to 3,
**characterised in that**
the annealing is performed between 5 and 40 seconds.

5. Method according to one of the claims 1 to 4,
**characterised in that**
the substrate (5) is etched in a solution (SC1) containing water, ammonium hydroxide and hydrogen peroxide to smooth the mesopores (15).

6. Method according to one of the claims 1 to 5,
**characterised in that**
the mesopores (15) are formed having a diameter between 10 nm and 50 nm.

7. Method according to one of the claims 1 to 6,
**characterised in that**
the ratio between diameter and depth of the mesopores (15) is between 0.25 to 4.

8. Method according to one of the claims 1 to 7,
**characterised in that**
the process parameters for oxidising the silicon containing substrate (5) are chosen in a way, that the silicon containing substrate (5) is oxidised to silicon monoxide, which is volatile and sublimates from the surface (10) of the semiconductor substrate (5).

9. Method according to one of the claims 5 to 8,
**characterised in that**
the substrate (5) is etched several times in the solution (SC1) to smooth the mesopores (15).
